(19) Europäisches Patentamt

European Patent Office

Office européen des brevets

(11) **EP 0 996 232 B1**

(12) **FASCICULE DE BREVET EUROPEEN**

(45) Date de publication et mention
de la délivrance du brevet:
**23.04.2003 Bulletin 2003/17**

(51) Int Cl.⁷: **H03M 13/27**, H04K 1/06

(21) Numéro de dépôt: **99126261.9**

(22) Date de dépôt: **31.05.1994**

(54) **Procédé et dispositif d'entrelacement d'une séquence d'éléments de données**

Verfahren und Vorrichtung zur Verschachtelung einer Folge von Datenelementen

Method and apparatus for interleaving a sequence of data elements

(84) Etats contractants désignés:
**BE CH DE ES FR GB IT LI LU NL PT SE**

(30) Priorité: **02.06.1993 FR 9306574**

(43) Date de publication de la demande:
**26.04.2000 Bulletin 2000/17**

(62) Numéro(s) de document de la (des) demande(s)
initiale(s) en application de l'article 76 CBE:
**94401201.2 / 0 627 821**

(73) Titulaire: **ALCATEL**
**75008 Paris (FR)**

(72) Inventeurs:
• **De Seze, Fabrice**
**75017 Paris (FR)**

• **Gourgue, Frédéric**
**75017 Paris (FR)**

(74) Mandataire: **El Manouni, Josiane**
**Compagnie Financière Alcatel**
**Départememt de Propriété Industrielle,**
**5, rue Noel Pons**
**92734 Nanterre Cedex (FR)**

(56) Documents cités:
**EP-A- 0 235 477          US-A- 3 652 998**

• **G. C. CLARK, JR. & J. BIBB CAIN:
"ERROR-CORRECTION CODING FOR DIGITAL
COMMUNICATIONS" 1981 , PLENUM PRESS ,
NEW YORK (US) XP002131001 * page 349 - page
352 * * page 349, ligne 11 - ligne 17 * * page 350,
ligne 18 - page 351, ligne 9 ***

**Description**

L'invention concerne l'entrelacement des éléments de données de signaux numériques source. Les techniques d'entrelacement trouvent de nombreuses applications dans le domaine du traitement des signaux numériques, notamment en vue du cryptage et/ou de la transmission de ces signaux.

Ainsi, dans le cas de la transmission (ou la diffusion) numérique, l'entrelacement permet de supprimer ou à tout le moins de limiter les problèmes dus aux perturbations diverses du canal de transmission, telles que, notamment, les phénomènes d'évanouissement rapide ou de parasites impulsifs.

En effet, les signaux de données sont codés à l'aide de codes correcteurs d'erreurs, tels que des codes convolutifs, qui permettent de reconstruire à réception le signal source, même lorsque certains éléments de données sont reçus sous une forme erronée. Toutefois, une telle correction est possible uniquement s'il y a un nombre limité r d'éléments de données erronés parmi p éléments de données consécutifs (p et r étant fonction du code utilisé). Or il n'est pas rare qu'un évanouissement ait une durée correspondant à la transmission de plusieurs éléments de données consécutifs.

L'entrelacement permet de pallier cet inconvénient, en réordonnant les éléments de données de façon que deux éléments de données du signal source distants de moins de p soient suffisamment distants l'un de l'autre dans le signal transmis (entrelacé) pour qu'ils ne puissent pas être affectés tous les deux par un même évanouissement.

L'efficacité d'un entrelaceur se mesure à sa capacité à scinder un bloc d'erreurs important. Cela peut se formaliser de la manière suivante, q étant la longueur en nombre de bits du bloc d'erreur à scinder, et p le nombre de bits consécutifs sur lequel il est souhaitable de ne pas avoir d'accumulation d'erreurs : l'entrelaceur est adapte si deux bits choisis parmi q bits consécutifs après entrelacement sont distants d'au moins p bits avant entrelacement.

On connaît actuellement essentiellement deux techniques d'entrelacement : l'entrelacement matriciel et l'entrelacement convolutif.

La technique de l'entrelacement matriciel consiste à écrire les éléments de données d'une séquence source dans une matrice ligne par ligne, et à relire ces éléments de données colonne par colonne, pour former une séquence entrelacée.

Pour assurer un décodage sans problème, on sait que le nombre de lignes de la matrice doit être supérieur ou égal au nombre maximal (q) d'éléments de données que peut contenir un évanouissement (ou, plus précisément, que contient un évanouissement de durée maximale tolérée par le système de transmission), et que le nombre de colonnes de la matrice doit être supérieur ou égal au nombre p d'éléments de données consécutifs parmi lesquels il ne doit pas se trouver plus d'un élément de données erroné.

Cela impose donc que la longueur de chaque séquence entrelacée soit de L = xy éléments de données consécutifs. Or, il n'est pas toujours possible de respecter cette contrainte, notamment lorsque la longueur N de chaque séquence est imposée par le système de transmission. C'est en particulier le cas lorsque N est premier, ou plus généralement lorsqu'il n'existe pas deux entiers x et y remplissant les conditions ci-dessus et divisant N. N peut par exemple être le nombre d'éléments de données que contient une unité de protocole (trame, paquet, ...) gérée par le système.

Un autre inconvénient de la technique matricielle est que le premier et le dernier éléments de données inscrits ne sont pas déplacés. En conséquence, si l'on traite deux séquences de L éléments de données, le premier élément de la deuxième séquence restera le successeur direct du dernier élément de la première séquence, même après entrelacement. Si un évanouissement se produit durant la transmission de ces éléments, le décodage peut ne pas être possible.

L'entrelacement convolutif est adapté à la transmission de bits en série dans la mesure où l'entrelaceur (et le désentrelaceur) prennent et délivrent les bits un à un. contrairement au cas précédent pour lequel les bits sont accumulés avant d'être entrelacés (ou désentrelacés) puis délivrés en bloc. On montre que ce type d'entrelaceur introduit des bits de bourrage, ce qui réduit la capacité des systèmes, notamment lorsque les messages à transmettre sont courts.

Un inconvénient majeur de la technique de l'entrelacement convolutif est qu'elle entraîne l'introduction d'éléments de bourrage parmi les éléments de données utiles. Il en résulte donc une perte d'efficacité du système de transmission, en terme de débit.

Il est en outre connu, du document EP-A-0 235 477, un procédé d'entrelacement d'une séquence de B mots codés de n symboles chacun, dans lequel ces mots codés sont rangés dans B lignes de chacune n symboles d'une matrice d'entrelacement, et dans lequel l'entrelacement est réalisé grâce à une séquence de lecture particulière de la matrice, définie par la suite:

$x_k = x_0 + kp$ (modulo Bn), où $x_0$ est un rang de départ, et où p est le pas de la suite, p étant un nombre entier premier avec Bn, et k prenant les valeurs 0, 1, ...Bn-1. L'objectif de ce document est de réaliser un entrelacement permettant d'obtenir une transmission résistante au brouillage par un brouilleur périodique émettant des impulsions de brouillage espacées régulièrement dans le temps de B symboles (ce que ne permet pas d'obtenir l'entrelacement matriciel clasique), et sans utiliser de lecture de la matrice suivant une loi pseudo-aléatoire (afin de respecter une valeur minimale d'espacement entre les symboles d'un même mot codé).

On peut aussi se référer à Clark et Caïn : « Error correcting coding for digital communication », 1981, pages 349-352, Plenum Press.

L'invention a notamment pour objectif de pallier ces différents inconvénients de l'état de la technique.

Plus précisément, un objectif essentiel de l'invention est de fournir un procédé d'entrelacement des éléments de données d'une séquence comprenant N éléments de données, quelle que soit la valeur de N. En d'autres termes, l'invention a pour objectif de fournir un tel procédé permettant l'entrelacement bloc par bloc de blocs d'éléments (paquets, trames ...) de taille quelconque.

Un autre objectif de l'invention est de fournir un tel procédé, qui puisse optimiser l'entrelacement des éléments de données en fonction de la structure du signal à transmettre (architectures des unités de protocole, techniques de transmission par exemple).

L'invention a également pour objectif de fournir un tel procédé d'entrelacement, introduisant un écart suffisant entre des éléments de données consécutifs d'une séquence de N éléments de données, mais également entre des éléments de données de deux séquences consécutives.

Un autre objectif de l'invention est encore de fournir un tel procédé, n'entraînant pas de modification, c'est-à-dire de réduction, du débit du signal traité.

Un objectif particulier de l'invention est de fournir un tel procédé, qui soit simple à mettre en oeuvre, et peu consommateur r en temps de traitement, en nombre d'opérations à effectuer et en capacité de mémoire.

Ces objectifs, ainsi que d'autres qui apparaîtront par la suite, sont atteints selon l'invention grâce à un procédé d'entrelacement d'une séquence source comprenant N éléments de données, délivrant une séquence entrelacée correspondant à ladite séquence source,

ledit procédé comprenant au moins une étape d'entrelacement associant l'élément de données d'indice j de ladite séquence entrelacée à l'élément de données d'indice i de ladite séquence source, la valeur j étant déterminée à partir de la valeur i de la façon suivante :

$$j = (a.i + b) \ [\text{modulo } N] + 1$$

où: $1 \le i \le N$ et $1 \le j \le N$ ;

a est un nombre entier prédéterminé premier avec N et tel $2 \le a \le N-1$; et

b est un nombre entier prédéterminé tel que : $0 \le b \le N-1$.

Ainsi, la longueur N de la séquence source peut prendre une valeur quelconque et le procédé selon l'invention permet de s'affranchir des contraintes liées à l'entrelacement matriciel, et notamment à celle selon laquelle la longueur de la séquence entrelacée doit être égale à $L = xy$ éléments de données.

Par ailleurs, les premier et dernier éléments de données de chaque séquence source sont déplacés. Ainsi, le procédé selon l'invention introduit un écart suffisant non seulement entre les éléments de données consécutifs d'une même séquence, mais également entre les éléments de données consécutifs de deux séquences consécutives (à savoir le dernier élément de l'une et le premier élément de l'autre).

Enfin, le procédé selon l'invention n'introduit aucun élément de bourrage. Ceci permet d'éviter une réduction du débit du signal traité.

Avantageusement, lesdits éléments de données sont préalablement codés à l'aide d'un code correcteur d'erreurs tolérant au plus r erreurs parmi p éléments de données consécutifs dans ladite séquence source, et le nombre a est supérieur ou égal au nombre p.

Le nombre a correspond à l'espacement minimal, en nombre d'éléments de données, entre deux éléments de la séquence source (ainsi théoriquement que de la séquence désentrelacée) correspondant à deux éléments de données consécutifs de la séquence entrelacée.

Par conséquent, en prenant $a \ge p$ on s'assure qu'en réception, un décalage adéquat permet de corriger les éléments erronés lorsque deux erreurs consecutives (c'est-à-dire deux éléments erronés consécutifs) sont séparées par au moins p elements de données sans erreur.

De façon avantageuse, ladite séquence entrelacée est destinée à être transmise sur un canal de transmission vers un récepteur, ledit canal pouvant présenter des évanouissements de durée maximale q.T sans affecter la réception dans ledit récepteur. T étant la durée de transmission d'un élément de données et q étant un entier,

et le nombre a est choisi de façon que : $E(N/a) \ge q$,

la fonction E() étant la fonction associant à un nombre réel sa partie entière.

De cette façon, on s'assure que, dans la séquence entrelacée, les éléments de données erronés du fait d'un même évanouissement (éléments qui sont donc successifs et au nombre de q au maximum) ne sont pas adjacents dans la séquence source.

Préférentiellement, le nombre a est choisi de façon à maximiser la plus petite des deux valeurs a et $E(N/a)$, la fonction E() étant la fonction associant à un nombre réel sa partie entière.

De cette façon on réalise un compromis entre les deux contraintes précédentes, à savoir $a \ge p$ et $E(N/a) \ge q$.

De façon préférentielle, ledit procédé est appliqué à l'entrelacement de signaux numériques organisés en blocs d'éléments de données comprenant chacun N éléments de données.

Dans un mode de réalisation préférentiel de l'invention, ledit procédé est mis en oeuvre dans un système de transmission d'éléments de données par trames, chacune desdites trames comprenant au moins un paquet, chacun desdits paquets comprenant au moins deux zones d'éléments de données utiles séparées par au moins une zone d'éléments de données de structure,

ladite étape d'entrelacement étant effectuée uniquement sur lesdits éléments de données utiles.

De cette façon, l'efficacité de l'entrelacement est encore améliorée puisque les zones d'éléments de structure, à savoir notamment les entêtes de trame, les zones situées en début, milieu et fin de paquet (zones appelées par la suite "préambule", "midambule" et "postambule" respectivement) permettent d'augmenter l'écart entre éléments de données après entrelacement.

Les N éléments de données à entrelacer d'un bloc proviennent soit d'un même paquet, soit de plusieurs paquets consécutifs (constituant une trame par exemple).

Avantageusement, ledit procédé comprend une étape de détermination des nombres a et b tenant compte d'au moins un des paramètres appartenant au groupe comprenant :

- la structure desdites trames ;
- la structure desdits paquets.

Dans le cas d'une mise en oeuvre du procédé selon l'invention dans un système de transmission à sauts de fréquence utilisant au moins deux fréquences de transmission. ledit groupe de paramètres comprend également :

- la fréquence utilisée à un moment donné ;
- les instants de saut de fréquence.

Dans un mode de réalisation préférentiel de l'invention, ledit procédé comprend les étapes suivantes de :

- détermination d'une fonction $f_{N,a,b}$ paramètrée par le triplet (N, a, b) et telle que $q = f_{N,a,b}$ (p), où :

  * p est le nombre d'éléments de données successifs de ladite séquence source sur lesquels on souhaite ne pas avoir d'accumulation d'erreur de façon qu'un code correcteur d'erreurs permette de corriger des éléments de données erronés ;
  * q est le nombre maximal d'éléments de données erronés successifs de ladite séquence entrelacée correspondant à un évanouissement qu'un canal de transmission sur lequel ladite séquence entrelacée est transmise peut induire sans affecter la réception dans un récepteur placé en sortie dudit canal de transmission.

- calcul, pour chaque valeur distincte dudit triplet (N, a, b), d'une valeur $p_{min}$ du nombre p telle que $p_{min}$ soit la valeur maximale de p pour laquelle $f_{N,a,b}(p)$ devient inférieure ou égale à p ;
- choix des nombres a et b correspondant à la valeur $p_{min}$ maximale.

On peut montrer que quelle que soit la valeur du triplet (N, a, b), la fonction $f_{N,a,b}$ est décroissante et possède au moins un point d'intersection avec la première bissectrice.

Il est à noter que N est généralement imposé par le système de transmission, par exemple du fait de la structure des trames ou des paquets.

Dans un mode de réalisation avantageux de l'invention, lesdits éléments de données sont des éléments binaires et ledit procédé est mis en oeuvre dans un système de radiocommunication numérique.

Avantageusement, ledit procédé comprend au moins deux étapes d'entrelacement consécutives. une première étape d'entrelacement associant l'élément de données d'indice j d'une séquence intermédiaire à l'élément de données d'indice i de ladite séquence source, la valeur j étant déterminée à partir de la valeur i de la façon suivante :

$$j = (a_1.i + b_1) \text{ [modulo N]} + 1$$

et une seconde étape d'entrelacement associant l'élément de données d'indice j de ladite séquence entrelacée à l'élément de données d'indice i de ladite séquence intermédiaire, la valeur j étant déterminée à partir de la valeur i de la façon suivante :

$$j = (a_2.i + b_2) \text{ [modulo N]} + 1$$

où : $a_1$ et $a_2$ sont des nombres entiers prédéterminés premiers avec N ; et

$b1$ et $b_2$ sont des nombres entiers prédéterminés tels que :

$0 \leq b_1 \leq N\text{-}1$ et $0 \leq b_2 \leq N\text{-}1$.

Ceci correspond à un entrelacement multiple. Le principe de chacune des étapes d'entrelacement successives est similaire au principe précédemment exposé dans le cas d'une unique étape d'entrelacement.

L'invention concerne également un dispositif d'entrelacement comprenant des moyens de mise en oeuvre d'un procédé d'entrelacement selon l'invention.

D'autres caractéristiques et avantages de l'invention apparaîtront à la lecture de la description suivante d'un mode de réalisation préférentiel de l'invention, donné à titre d'exemple indicatif et non limitatif, et des dessins annexés dans lesquels :

- la figure 1 présente un schéma par blocs d'un système de transmission permettant d'expliquer le principe général de l'entrelacement ;
- la figure 2 présente un exemple de table de correspondance entre les indices des éléments d'une séquence source et les indices des éléments d'une séquence entrelacée obtenus avec un mode de réalisation particulier du procédé selon l'invention ;
- la figure 3 présente un exemple de structuration d'un train d'éléments de données transmis dans un système tel que présenté sur la figure 1, cette structuration étant particulièrement adaptée à une mise en oeuvre avantageuse du procédé de l'invention ; et

- la figure 4 présente trois exemples de variation du nombre $q = f_{N,a,b}(p)$ en fonction du nombre p, chaque exemple correspondant à une valeur distincte du triplet (N, a, b).

L'invention concerne donc un procédé d'entrelacement, ainsi qu'un dispositif d'entrelacement (ou entrelaceur) mettant en oeuvre un tel procédé.

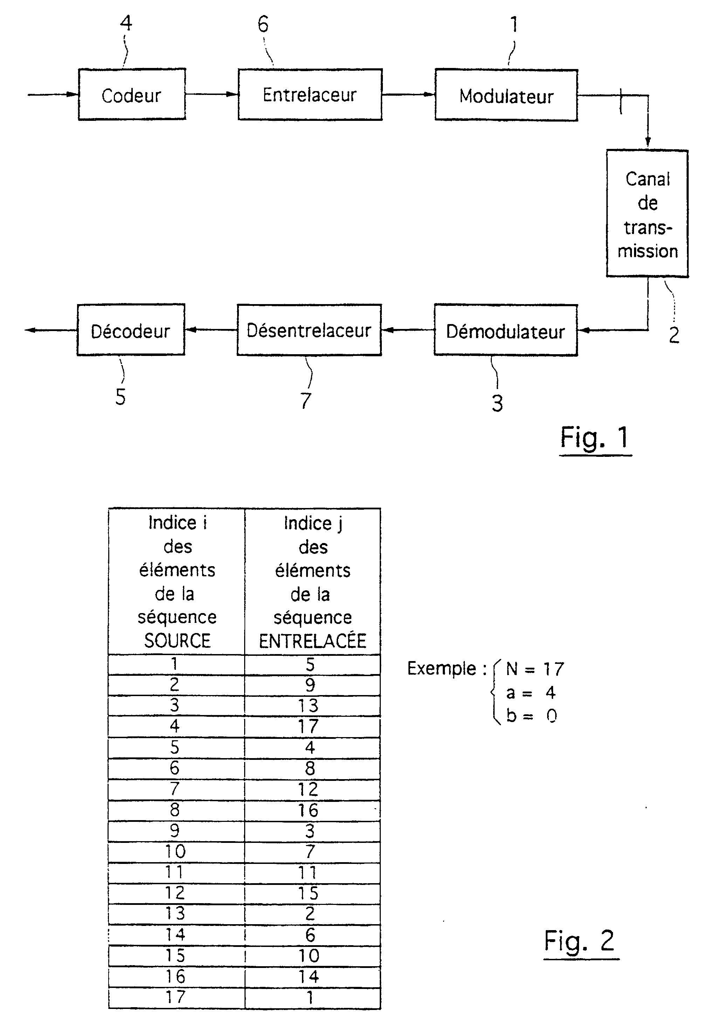

La figure 1 présente un schéma par blocs d'un système de transmission permettant d'expliquer le principe général de l'entrelacement.

Le signal à transmettre est mis en forme par un modulateur 1 avant d'être envoyé sur le canal de transmission 2. Or, ce canal de transmission 2 dégrade le signal, ce qui provoque des erreurs en sortie du démodulateur 3. Cette dégradation du signal est partiellement compensée par l'utilisation d'un code correcteur d'erreurs mis en oeuvre d'une part dans un codeur 4 situé en amont du modulateur 1 (codage de canal) et d'autre part dans un décodeur 5 situé en aval du démodulateur 3 (décodage).

L'expérience montre que les erreurs induites par le canal de transmission 2 peuvent se produire par paquets. On parle alors d'évanouissements dont la longueur peut être mesurée en nombre d'éléments de données erronés consécutifs. De tels évanouissements se produisent notamment avec les canaux rencontrés en radiomobile.

Or les codes correcteurs d'erreurs sont plus efficaces lorsque les erreurs sont isolées. C'est pourquoi on place un entrelaceur 6 entre le codeur 4 et le modulateur 1, ainsi qu'un désentrelaceur entre le démodulateur 3 et le décodeur. Ainsi, on entrelace le flux binaire avant émission, puis ou le désentrelace à la réception, de façon à scinder les paquets d'erreurs et améliorer l'efficacité du code correcteur d'erreurs.

Le procédé d'entrelacement de l'invention est du type délivrant une séquence entrelacée correspondant à une séquence source comprenant N éléments de données.

Ce procédé comprend au moins une étape d'entrelacement telle que l'élément de données d'indice i de la séquence source soit déplacé et corresponde à l'élément de données d'indice j de la séquence entrelacée, la valeur j étant déterminée à partir de la valeur i de la façon suivante :

$$j = (a.i + b) \text{ [modulo N] } + 1$$

où :

* a est un nombre entier prédéterminé premier avec N et tel que : $2 \leq a \leq N-1$ ; et
* b est un nombre entier prédéterminé tel que : $O \leq b \leq N-1$.

La figure 2 présente un exemple de table de correspondance entre les indices des éléments d'une séquence source et les indices des éléments d'une séquence entrelacée d'éléments de données. Dans ce mode de réalisation particulier, on a N = 17 , a = 4 et b = 0.

Ainsi, par exemple, l'élément de données occupant la quatorzième place dans la séquence source (indice 14) occupe la sixième place dans la séquence entrelacée (indice 6). En effet, on a : (4 x 14 + 0) [modulo 17] + 1 = 5 + 1 = 6.

Par la suite, on considére que le code correcteur d'erreurs utilisé est du type tolérant au plus une erreur parmi p éléments de données consécutifs dans la séquence source. En d'autres termes, p est le nombre d'éléments de données consécutifs sur lequel il est souhaitable de ne pas avoir d'accumulation d'erreurs.

Dans ce cas, le procédé selon l'invention est tel que le nombre a est choisi de façon que : $a \geq p$.

Dans la suite de la description, on considère également que le canal de transmission peut présenter des évanouissements de durée maximale q.T, avec T la durée de transmission d'un élément de données et q un entier. En d'autres termes, q est la longueur (en nombre d'éléments de données) du paquet d'erreurs à scinder.

Dans ce cas, le procédé selon l'invention est tel que le nombre a est choisi de façon que : $E(N/a) \geq q$, où E est la fonction associant à un nombre réel sa partie entière.

Un exemple de compromis entre les deux contraintes sur a, à savoir $a \geq p$ et $E(N/a) \geq q$, consiste par exemple à choisir le nombre a de façon à maximiser la plus petite des deux valeurs a et E(N/a). En d'autres termes, il s'agit de déterminer le nombre a maximisant la fonction : $\text{Max}_a [\text{Min}(a, E(N/a))]$.

Ainsi, lorsque ces deux contraintes sont respectées, l'entrelacement est adapté au code correcteur d'erreur d'une part et au canal de transmission d'autre part. Autrement dit, deux éléments de données choisis parmi q éléments consécutifs après entrelacement sont distants d'au moins p éléments de données avant entrelacement.

b peut être assimilé à une phase. La valeur de b est choisie de façon à obtenir l'entrelacement le plus efficace. Ce choix peut tenir compte de nombreux paramètres, et notamment de la structure du bloc à entrelacer.

Il est à noter qu'afin d'améliorer encore l'entrelacement, le procédé selon l'invention peut comprendre au moins deux étapes successives d'entrelacement du type décrit précédemment. Ainsi, dans le cas où il y a deux étapes successives, les éléments de la séquence source sont d'abord entrelacés afin de constituer une séquence intermédiaire, puis les éléments de la séquence intermédiaire sont entrelacés afin de constituer la séquence entrelacée émise dans le canal de transmission.

En notant i, j et k l'indice d'un même élément de données dans la séquence source, la séquence intermédiaire et la séquence entrelacée respectivement, on a :

$$j = (a_1.i + b_1) \text{ [modulo N]} + 1$$

$$k = (a_2.i + b_2) \text{ [modulo n]} + 1$$

où :

* $a_1$ et $a_2$ sont des nombres entiers prédéterminés premiers avec N ; et

* $b_1$ et $b_2$ sont des nombres entiers prédéterminés tels que :

$$0 \leq b_1 \leq N\text{-}1 \text{ et } 0 \leq b_2 \leq N\text{-}1.$$

Les différents coefficients ($a_1$, $a_2$, $b_1$, $b_2$) sont choisis de façon que l'entrelacement global obtenu par la succession des deux étapes d'entrelacement soit tel que deux éléments de données choisis parmi q éléments consécutifs après entrelacement sont distants d'au moins p éléments de données avant entrelacement.

Le nombre N d'éléments de données de la séquence source à entrelacer pouvant prendre n'importe quelle valeur prédéterminée, le procédé de l'invention est parfaitement adapté à l'entrelacement de signaux numériques organisés en blocs d'éléments de données comprenant chacun N éléments de données.

Un mode de réalisation particulier du procédé de l'invention est décrit ci-dessous dans le cas d'un système de radiocommunication numérique, les éléments de données étant dans ce cas des éléments binaires. Il est clair toutefois que le procédé de l'invention n'est pas limité à une telle application et qu'il peut aisément être adapté à de nombreux autres cas, sans sortir du cadre de l'invention.

Dans un système de radiocommunication numérique, les éléments de données (ou éléments binaires plus précisément) sont transmis par trames.

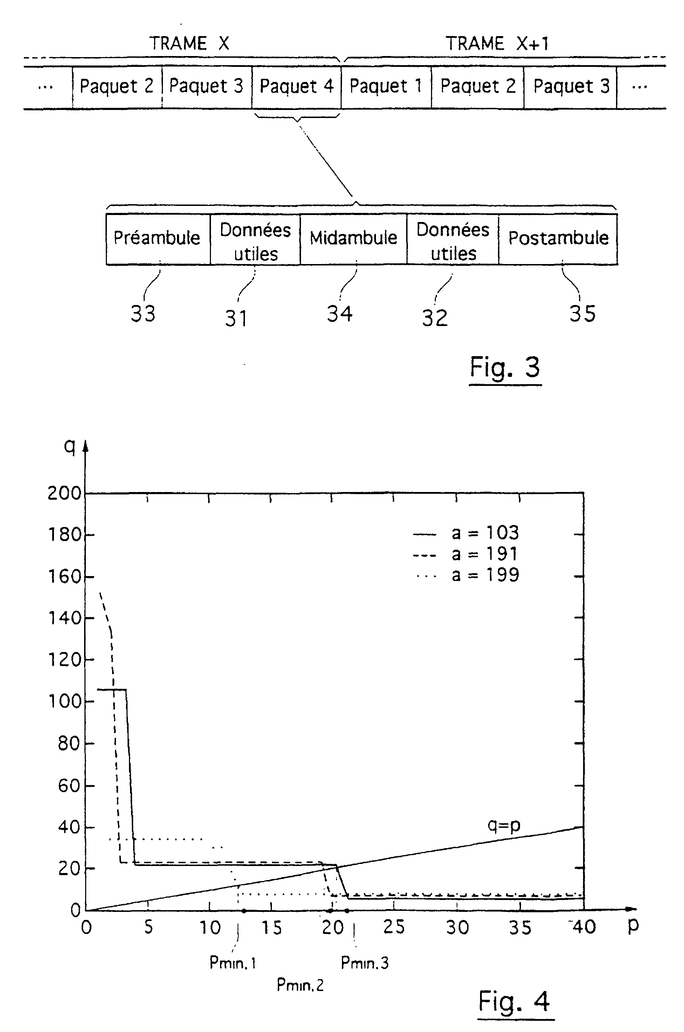

La figure 3 présente un exemple de structuration d'un train d'éléments binaires à transmettre. Le train est constitué d'une succession de trames (..., TRAME X, TRAME (X + 1),...). Chaque trame est elle même constituée d'une succession de paquets, quatre dans cet exemple, (PAQUET 1 à PAQUET 4). Dans le cas d'un système TDMA ("Time Division Multiple Access" en anglo-saxon), les paquets dédiés à une communication donnée ne reviennent qu'avec une certaine récurrence. Ainsi, dans l'exemple présenté, à savoir le système TDMA 4, quatre communications sont multiplexées temporellement et les paquets d'une même communication reviennent tous les quatre paquets.

Enfin, chaque paquet contient cinq zones :

- d'une part, trois zones d'éléments de données de structure. placées en début, milieu et fin de paquet et appelées respectivement "préambule", "midambule" et "postambule" par la suite ; et

- d'autre part, deux zones d'éléments de données utiles.

Les zones 31, 32 d'éléments de données utiles transportent l'information en tant que telle, alors que les zones 33 à 35 d'éléments de données de structure sont requises pour le fonctionnement du système mais limitent le débit d'information utile transmise par le système.

L'entrelacement n'affecte que les éléments binaires d'information (c'est-à-dire les éléments de données utiles des zones référencées 31, 32).

Un bloc de N éléments de données constituant une séquence source peut donc correspondre aux éléments binaires d'un même paquet ou bien de plusieurs paquets. Une telle utilisation de la structure de trames et de paquets permet d'augmenter l'efficacité de l'entrelacement. En effet, les zones d'éléments de données de structures accroissent l'écart entre les éléments binaires d'information après l'entrelacement. Ceci revient à augmenter la valeur possible de q, pour une valeur donnée de p.

Une étape de détermination des nombres a et b précède généralement l'étape d'entrelacement. Ainsi, dans le cas d'un système de transmission par paquets, l'étape de détermination consiste à choisir les nombres a et b en tenant compte de la structure des trames et/ ou de la structure des paquets.

Par ailleurs, lorsque le procédé est mis en oeuvre dans un système de transmission à sauts de fréquence utilisant au moins deux fréquences de transmission, la fréquence utilisée à un moment donné et/ou les instants de saut de fréquence peuvent également être pris en compte lors de l'étape de détermination des nombres a et b.

Dans l'exemple qui suit, donné uniquement à titre indicatif, on se limite à l'entrelacement à l'intérieur d'un seul paquet. Dans ce cas, le midambule est mis à profit pour améliorer l'entrelacement des éléments de données utiles des deux zones correspondantes comprises dans le paquet.

Dans cet exemple, la première et la seconde zones 31 et 32 d'éléments de données utiles contiennent respectivement $n_1$ et $n_2$ éléments, avec $n_1 + n_2 = N$.

La séquence source est donc constituée de la concaténation :

- de $n_1$ éléments d'indice i compris entre 1 et $n_1$; et
- de $n_2$ éléments d'indice i compris entre ($n_1 + 1$) et N.

L'étape d'entrelacement consiste, comme déjà décrit auparavant, à déplacer le $i^{ème}$ élément de données utile de la séquence source de façon qu'il prenne la $j^{ème}$ place de la séquence entrelacée, avec j défini comme suit :

$$j = (a.i + b) \; [\text{modulo } N] + 1$$

où :

* a est un nombre entier prédéterminé premier avec N et tel que :
  $2 \leq a \leq$ N-1 ; ét
* b est un nombre entier prédéterminé tel que : $O \leq b \leq N$ -1.

Les nombres a et b sont par exemple déterminés de la façon suivante:

- on détermine une fonction $f_{N,a,b}$ paramétrée par le triplet (N, a, b) et telle que : $q = f_{N,a,b}(p)$ ;
- on calcule, pour chaque valeur distincte du triplet (N, a, b), une valeur pmin du nombre p telle que pmin soit la valeur maximale de p pour laquelle $f_{N,a,b}(p)$ devient inférieure ou égale à p ;
- on choisit les nombres a et b correspondant à la valeur $p_{min}$ maximale.

On peut montrer que cette fonction $f_{N,a,b}$ est décroissante et telle que :

* pour tout triplet (N, a, b), on a : $f_{N,a,b}$ (N) = 1 ;
* $f_{N,a,b}$ (1) $\geq$ 1.

Par conséquent, il existe toujours une valeur $p_{min}$, quelle que soit la valeur du triplet (N, a, b).
Un exemple d'utilisation d'une telle méthode d'optimisation du choix des nombres a et b est présenté en relation avec la figure 4. Dans cet exemple, on impose N = 432 et b = 0 et il s'agit de déterminer le nombre a.
Dans un souci de simplification, la figure 4 présente seulement trois exemples de variation du nombre $q = f_{N,a,b}$ (p) en fonction du nombre p, chaque exemple correspondant à une valeur distincte du triplet (N, a, b). Par conséquent, N et b étant fixé dans ce cas, chaque exemple correspond à une valeur distincte de a.
Ainsi :

- pour a = 199, on a $p_{min.1}$ = 13 ;
- pour a = 151 on a $p_{min.2}$ = 20 ;
- pour a = 103 on a $p_{min.3}$ = 21.

Par conséquent, on choisit a = 103 correspondant à la valeur $p_{min}$ maximale, à savoir $p_{min,3}$ = 21.
Il est clair que de nombreux autres modes de réalisation de l'étape de détermination des nombres a et b peuvent être envisagés.
Dans le cas général, on peut prévoir des simulations et des tests pour un jeu de différentes valeurs des nombres a et b, par exemple au moyen d'un dispositif de calcul numérique, les valeurs retenues étant celles s'avérant les plus efficaces vis-à-vis du décodage.
Il convient toutefois de vérifier que les nombres choisis permettent un entrelacement également adapté au canal de transmission.

**Revendications**

1. Procédé pour déterminer des paramètres d'un procédé d'entrelacement d'une séquence source comprenant N éléments de données, délivrant une séquence entrelacée correspondant à ladite séquence source, ledit procédé d'entrelacement comprenant au moins une étape d'entrelacement associant l'élément de données d'indice j de ladite séquence entrelacée à l'élément de données d'indice i de ladite séquence source, la valeur j étant déterminée à partir de la valeur i de la façon suivante :

$$j = (a.i + b) \; [\text{modulo } N] + 1$$

où: $1 \leq i \leq N$ et $1 \leq j \leq N$ ;
   a est un nombre entier prédéterminé premier avec N et tel que $2 \leq a \leq N-1$; et
   b est un nombre entier prédéterminé tel que : $0 \leq b \leq N-1$,
**caractérisé en ce que** les nombres a et b sont choisis au moyen des étapes suivantes :

- détermination d'une fonction $f_{N,a,b}$ paramètrée par le triplet (N, a, b) et telle que $q = f_{N,a,b}$ (p), où :

  * p est le nombre d'élément de données successsifs de ladite séquence source sur lesquels on souhaite ne pas avoir d'accumulation d'erreur de façon qu'un code correcteur permette de corriger des éléments de données erronés;
  * q est le nombre maximal d'éléments de données erronés successifs de ladite séquence entrelacée correspondant à un évanouissement qu'un canal de transmission sur lequel ladite séquence entrelacée est transmise peut induire sans affecter la réception dans un récepteur placé en sortie dudit canal de transmission;

- calcul pour chaque valeur distincte dudit triplet (N, a, b), d'une valeur $p_{min}$ du nombre p telle que $p_{min}$ soit la valeur maximale de p pour laquelle $f_{N,a,b}(p)$ devient inférieure ou égale à p ;

- choix des nombres a et b correspondant à la valeur $p_{min}$ maximale.

**2.** Procédé selon la revendication 1, dans lequel N est égal à 432, b est égal à 0, et a est égal à 103.

**3.** Procédé d'entrelacement d'une séquence source comprenant N éléments de données, délivrant une séquence entrelacée correspondant à ladite séquence source, ledit procédé comprenant au moins une étape d'entrelacement associant l'élément de données d'indice j de ladite séquence entrelacée à l'élément de données d'indice i de ladite séquence source, la valeur j étant déterminée à partir de la valeur i de la façon suivante :

$$j = (a.i + b) \ [modulo \ N] + 1$$

où: $1 \leq i \leq N$ et $1 \leq j \leq N$ ;

    a est un nombre entier prédéterminé premier avec N et tel que $2 \leq a \leq N-1$; et

    b est un nombre entier prédéterminé tel que : $0 \leq b \leq N-1$,

**caractérisé en ce que**, ledit procédé d'entrelacement étant mis en oeuvre dans un système de transmission d'éléments de données par trames (TRAME X, TRAME (X+1)), chacune desdites trames comprenant au moins un paquet (PAQUET 1 à PAQUET 4), chacun desdits paquets comprenant au moins deux zones (31, 32) d'éléments de données utiles séparées par au moins une zone (33 à 35) d'éléments de données de structure, ladite étape d'entrelacement est effectuée uniquement sur lesdits éléments de données utiles

    et **en ce que** N est égal à 432, b est égal à zero, et a est égal à 103.

**4.** Procédé selon la revendication 3, **caractérisé en ce que** le choix des nombres a et b tient compte d'au moins un des paramètres appartenant au groupe comprenant :

- la structure desdites trames ;
- la structure desdits paquets.

**5.** Procédé selon la revendication 4, du type mis en oeuvre dans un système de transmission à sauts de fréquence utilisant au moins deux fréquences de transmission, **caractérisé en ce que** ledit groupe de paramètres comprend également :

- la fréquence utilisée à un moment donné ;
- les instants de saut de fréquence.

**6.** Procédé selon l'une des revendications 1 à 5, **caractérisé en ce qu'**il est appliqué à l'entrelacement de signaux numériques organisés en blocs d'éléments de données comprenant chacun N éléments de données.

**7.** Procédé selon l'une quelconque des revendications 1 à 6, **caractérisé en ce que** lesdits éléments de données sont des éléments binaires.

**8.** Procédé selon l'une quelconque des revendications 1 à 7, **caractérisé en ce qu'**il est mis en oeuvre dans un système de radiocommunication numérique.

**9.** Procédé selon l'une des revendications 1 à 8, dans lequel N est égal à 432, b est égal à 0, et a est égal à 103.

**10.** Dispositif pour déterminer des paramètres d'un procédé d'entrelacement d'une séquence source comprenant N éléments de données, délivrant une séquence entrelacée correspondant à ladite séquence source, ledit procédé d'entrelacement comprenant au moins une étape d'entrelacement associant l'élément de données d'indice j de ladite séquence entrelacée à l'élément de données d'indice i de ladite séquence source, la valeur j étant déterminée à partir de la valeur i de la façon suivante

$$j = (a.i + b) \ [module \ N] + 1$$

où: $1 \leq i \leq N$ et $1 \leq j \leq N$ ;

    a est un nombre entier prédéterminé premier avec N et tel que $2 \leq a \leq N-1$; et

    b est un nombre entier prédéterminé tel que : $0 \leq b \leq N-1$,

**caractérisé en ce que** ledit dispositif comporte :

- des moyens de détermination d'une fonction $f_{N,a,b}$ paramétrée par le triplet (N, a, b) et telle que $q = f_{N,a,b} \ (p)$, où :

    * p est le nombre d'élément de données successsifs de ladite séquence source sur lesquels on souhaite ne pas avoir d'accumulation d'erreur de façon qu'un code correcteur permette de corriger des éléments de données erronés;

    * q est le nombre maximal d'éléments de données erronés successifs de ladite séquence entrelacée correspondant à un évanouissement qu'un canal de transmission sur lequel ladite séquence entrelacée est transmise peut induire sans affecter la réception dans un récepteur placé en sortie dudit canal de transmission;

- des moyens de calcul pour chaque valeur distincte dudit triplet (N, a, b), d'une valeur $p_{min}$ du

nombre p telle que $p_{min}$ soit la valeur maximale de p pour laquelle $f_{N,a,b}(p)$ devient inférieure ou égale à p;

- des moyens de choix des nombres a et b correspondant à la valeur $p_{min}$ maximale.

**11.** Dispositif selon la revendication 10, dans lequel N est égal à 432, b est égal à 0, et a est égal à 103.

**12.** Dispositif d'entrelacement (6) d'une séquence source comprenant N éléments de données, délivrant une séquence entrelacée correspondant à ladite séquence source, ledit dispositif d'entrelacement comprenant des moyens pour effectuer au moins une étape d'entrelacement associant l'élément de données d'indice j de ladite séquence entrelacée à l'élément de données d'indice i de ladite séquence source, la valeur j étant déterminée à partir de la valeur i de la façon suivante :

$$j = (a.i + b) \text{ [modulo N]} + 1$$

où: $1 \leq i \leq N$ et $1 \leq j \leq N$ ;

a est un nombre entier prédéterminé premier avec N et tel que $2 \leq a \leq N-1$; et

b est un nombre entier prédéterminé tel que : $0 \leq b \leq N-1$,

**caractérisé en ce que**, ledit dispositif étant mis en oeuvre dans un système de transmission d'éléments de données par trames (TRAME X, TRAME (X+1)), chacune desdites trames comprenant au moins un paquet (PAQUET 1 à PAQUET 4), chacun desdits paquets comprenant au moins deux zones (31, 32) d'éléments de données utiles séparées par au moins une zone (33 à 35) d'éléments de données de structure, ledit dispositif comporte des moyens pour effectuer ladite étape d'entrelacement uniquement sur lesdits éléments de données utiles,

et **en ce que**

N est égal à 432, b est égal à 0, et a est égal à 103.

**13.** Utilisation du procédé selon la revendication 1 dans um système de transmission d'éléments de données par trames (TRAME X, TRAME (X+1)), chacune desdites trames comprenant au moins un paquet (PAQUET 1 à PAQUET 4), chacun desdits paquets comprenant au moins deux zones (31, 32) d'éléments de données utiles séparées par au moins une zone (33 à 35) d'éléments de données de structure, ladite étape d'entrelacement est effectuée uniquement sur lesdits éléments de données utiles

**Patentansprüche**

**1.** Verfahren zum Bestimmen der Parameter eines Verfahrens zum Verschachteln einer Quellfolge mit N Datenelementen, welches eine der Quellfolge entsprechende verschachtelte Folge ergibt, wobei das Verschachtelungsverfahren wenigstens einen Verschachtelungsschritt umfasst, der das Datenelement mit Index j der verschachtelten Folge dem Datenelement mit Index i der Quellfolge zuordnet, wobei der Wert j aus dem Wert i in folgender Weise bestimmt wird:

$$j = (a.i+b) \text{ [modulo N]} +1,$$

wobei:

$$1 \leq i \leq N \text{ und } 1 \leq j \leq N;$$

a eine zu N teilerfremde ganze Zahl mit $2 \leq a \leq N-1$ ist, und

b eine vorgegebene ganze Zahl mit $0 \leq b \leq N-1$ ist,

**dadurch gekennzeichnet, dass** die Zahlen a und b mit Hilfe der folgenden Schritte ausgewählt werden:

- Bestimmen einer durch das Tripel (N,a,b) parametrisierten Funktion $f_{N,a,b}$ derart, dass $q = f_{N,a,b}(p)$ ist, wobei:

  * p die Anzahl von aufeinanderfolgenden Datenelementen der Quellfolge ist, an denen man keine Akkumulation von Fehlern haben will, so dass ein Korrekturcode es ermöglicht, fehlerhafte Datenelemente zu korrigieren;
  * q die maximale Zahl von aufeinanderfolgenden fehlerhaften Datenelementen der verschachtelten Folge ist, die einer Dämpfung entspricht, die ein Übertragungskanal, auf dem die verschachtelte Folge übertragen wird, induzieren kann, ohne den Empfang in einem am Ausgang des Übertragungskanals platzierten Empfänger zu beeinträchtigen;

- Berechnen, für jeden unterschiedlichen Wert des Tripels (N,a,b), eines Werts $p_{min}$ der Zahl p derart, dass $p_{min}$ der maximale Wert von p ist, für den $f_{N,a,b}(p)$ kleiner oder gleich p wird;
- Wählen der Zahlen a und b, die dem maximalen Wert $p_{min}$ entsprechen.

**2.** Verfahren nach Anspruch 1, bei dem N gleich 432, b gleich 0, und a gleich 103 ist.

**3.** Verfahren zum Verschachteln einer Quellfolge mit N Datenelementen, welches eine der Quellfolge entsprechende verschachtelte Folge ergibt, wobei das Verfahren wenigstens einen Verschachtelungsschritt umfasst, der das Datenelement mit Index j der verschachtelten Folge dem Datenelement mit Index i der Quellfolge zuordnet, wobei der Wert j anhand des Werts i in folgender Weise bestimmt wird:

$$j = (a.i+b) \ [modulo \ N] + 1,$$

wobei:

$$1 \leq i \leq N \ und \ 1 \leq j \leq N;$$

 a eine zu N teilerfremde vorgegebene ganze Zahl mit $2 \leq a \leq N\text{-}1$ ist, und
 b eine vorgegebene ganze Zahl mit $0 \leq b \leq N\text{-}1$ ist,
**dadurch gekennzeichnet, dass** bei Einsatz des Verschachtelungsverfahrens in einem System zur Übertragung von Datenelementen durch Rahmen (TRAME X, TRAME(X+1)),
wobei jeder dieser Rahmen wenigstens ein Paket (PAQUET 1 bis PAQUET 4) umfasst und jedes dieser Pakete wenigstens zwei Zonen (31, 32) von Nutzdatenelementen umfasst, die durch wenigstens eine Zone (33 bis 35) von Strukturdatenelementen getrennt sind, der Verschachtelungsschritt lediglich an den Nutzdatenelementen durchgeführt wird,
und dass N gleich 432, b gleich 0 und a gleich 103 ist.

**4.** Verfahren nach Anspruch 3, **dadurch gekennzeichnet, dass** die Auswahl der Zahlen a und b wenigstens einen der Parameter berücksichtigt, die zu der Gruppe gehören, welche umfasst :

 - die Struktur der Rahmen,
 - die Struktur der Pakete.

**5.** Verfahren nach Anspruch 4 vom Typ, der in einem Frequenzsprung-Übertragungssystem angewendet wird, das wenigstens zwei Übertragungsfrequenzen verwendet, **dadurch gekennzeichnet, dass** die Gruppe von Parametern ferner umfasst:

 - die zu einem gegebenen Moment verwendete Frequenz;

 - die Zeitpunkte der Frequenzsprünge.

**6.** Verfahren nach einem der Ansprüche 1 bis 5, **dadurch gekennzeichnet, dass** es angewendet wird auf die Verschachtelung von digitalen Signalen, die in Blöcken von Datenelementen mit jeweils N Datenelementen organisiert sind.

**7.** Verfahren nach einem beliebigen der Ansprüche 1 bis 6, **dadurch gekennzeichnet, dass** die Datenelemente binäre Elemente sind.

**8.** Verfahren nach einem beliebigen der Ansprüche 1 bis 7, **dadurch gekennzeichnet, dass** es in einem digitalen Funkkommunikationssystem verwendet wird.

**9.** Verfahren nach einem der Ansprüche 1 bis 8, bei dem N gleich 432, b gleich 0 und a gleich 103 ist.

**10.** Vorrichtung zum Bestimmen der Parameter eines Verfahrens zum Verschachteln einer Quellfolge mit N Datenelementen, welches eine der Quellfolge entsprechende verschachtelte Folge ergibt, wobei das Verschachtelungsverfahren wenigstens einen Verschachtelungsschritt umfasst, der das Datenelement mit Index j der verschachtelten Folge dem Datenelement mit Index i der Quellfolge zuordnet, wobei der Wert von j anhand des Werts i in folgender Weise bestimmt wird:

$$j = (a.i+b) \ [modulo \ N]+1,$$

wobei:

$$1 \leq i \leq N \ und \ 1 \leq j \leq N;$$

 a eine zu N teilerfremde vorgegebene erste Zahl mit $2 \leq a \leq N\text{-}1$ ist, und
 b eine vorgegebene ganze Zahl mit $0 \leq b \leq N\text{-}1$ ist,
**dadurch gekennzeichnet, dass** die Vorrichtung umfasst:

 - Mittel zum Bestimmen einer durch das Tripel (N,a,b) parametrisierten Funktion $f_{N,a,b}$ derart, dass $q = f_{N,a,b}(p)$, wobei:

  * p die Zahl von aufeinanderfolgenden Datenelementen der Quellfolge ist, an denen man keine Fehlerakkumulation haben will, so dass ein Korrekturcode es erlaubt, fehlerhafte Datenelemente zu korrigieren;
  * q die maximale Zahl von aufeinanderfolgenden fehlerhaften Datenelementen der verschachtelten Folge ist, die einer Dämpfung entspricht, die ein Übertragungskanal, auf dem die verschachtelte Folge übertragen wird, induzieren kann, ohne den Empfang in einem am Ausgang des Übertragungskanals platzierten Empfänger zu beeinträchtigen;

- Mittel zum Berechnen, für jeden unterschiedlichen Wert des Tripels (N,a,b), eines Werts $p_{min}$ der Zahl p derart, dass $p_{min}$ der maximale Wert von p ist, für den $f_{N,a,b}(p)$ kleiner oder gleich p wird;
- Mittel zum Auswählen der Zahlen a und b, die dem maximalen Wert $p_{min}$ entsprechen.

**11.** Vorrichtung nach Anspruch 10, bei der N gleich 432, b gleich 0 und a gleich 103 ist.

**12.** Vorrichtung (6) zum Verschachteln einer Quellfolge mit N Datenelementen, die eine der Quellfolge entsprechende verschachtelte Folge liefert, wobei die Verschachtelungsvorrichtung Mittel zum Durchführen wenigstens eines Verschachtelungsschritts umfasst, der das Datenelement mit Index j der verschachtelten Folge dem Datenelement mit Index i der Quellfolge zuordnet, wobei der Wert j anhand des Werts i in folgender Weise bestimmt ist:

$$j = (a.i+b) \ [modulo \ N]+1,$$

wobei:

$$1 \leq i \leq N \ und \ 1 \leq j \leq N;$$

a eine zu N teilerfremde vorgegebene ganze Zahl mit $2 \leq a \leq N-1$ ist, und

b eine vorgegebene ganze Zahl mit $0 \leq b \leq N-1$ ist,

**dadurch gekennzeichnet, dass** bei Anwendung der Vorrichtung in einem System zur Übertragung von Datenelementen durch Rahmen (TRAME X, TRAME(X+1)), wobei jeder der Rahmen wenigstens ein Paket (PAQUET 1 bis PAQUET 4) umfasst,

wobei jedes der Pakete wenigstens zwei Zonen (31, 32) von Nutzdatenelementen umfasst, die durch wenigstens eine Zone (33 bis 35) von Strukturdatenelementen getrennt sind, die Vorrichtung Mittel zum Durchführen des Verschachtelungsschritts lediglich an den Nutzdatenelementen umfasst.

**13.** Anwendung des Verfahrens nach Anspruch 1 in einem System zur Übertragung von Datenelementen durch Rahmen (TRAME X, TRAME(X+1)), wobei jeder dieser Rahmen wenigstens ein Paket (PAQUET 1 bis PAQUET 4) umfasst, jedes der Pakete wenigstens zwei Zonen (31, 32) von Nutzdatenelementen umfasst, die durch wenigstens eine Zone (33 bis 35) von Strukturdatenelementen getrennt sind, und der Verschachtelungsschritt nur an den Nutzdatenelementen durchgeführt wird.

**Claims**

**1.** Method of determining the parameters of a method of interleaving a source sequence comprising N data elements delivering an interleaved sequence corresponding to said source sequence, said method of interleaving comprising at least one interleaving stage associating the data element of index j of said interleaved sequence to the data element of index i of said source sequence, the value j being determined from the value i as follows:

$$j = (a.i + b) \ [modulo \ N] + 1$$

where:
$1 \leq i \leq N$ and $1 \leq j \leq N$;
a is a predetermined integer relatively prime with N and such that:
$2 \leq a \leq N-1$; and
b is a predetermined integer such that:
$0 \leq b \leq N-1$,
**characterized in that** the numbers a and b are chosen by means of the following stages:

- determining a function $f_{N,a,b}$ parametered by the triplet (N, a, b) and such that $q = f_{N,a,b}(p)$, where:

  * p is the number of successive data elements of said source sequence in which there is to be no accumulation of errors so that an error correcting code can correct erroneous data elements;
  * q is the maximum number of successive erroneous data elements of said interleaved sequence corresponding to a fade that a transmission medium on which said interleaved sequence is transmitted can cause without affecting reception at a receiver at the output end of said transmission medium;

- calculating, for each separate value of said triplet (N, a, b), a value $p_{min}$ of the number p such that $p_{min}$ is the maximum value of p for which $f_{N,a,b}(p)$ becomes less than or equal to p;
- choosing numbers a and b corresponding to the maximum value $p_{min}$.

**2.** Method according to claim 1 wherein N is 432, b is 0 and a is 103.

**3.** Method of interleaving a source sequence comprising N data elements delivering an interleaved sequence corresponding to said source sequence, said method of interleaving comprising at least one interleaving stage associating the data element of index $j$ of said interleaved sequence to the data element of index $i$ of said source sequence, the value $j$ being determined from the value $i$ as follows:

$$j = (a.i + b) \text{ [modulo N] } + 1$$

where:
$1 \leq i \leq N$ and $1 \leq j \leq N$;
$a$ is a predetermined integer relatively prime with N and such that:
$2 \leq a \leq N-1$; and
$b$ is a predetermined integer such that:
$0 \leq b \leq N-1$,
**characterized in that**, said method of interleaving being employed in a system for transmitting data elements in frames (FRAME X, FRAME (X + 1)), each of said frames comprising at least one packet (PACKET 1 to PACKET 4), each of said packets comprising at least two wanted data element areas (31, 32) separated by at least one structure data element area (33 to 35), said interleaving stage is applied only to said wanted data elements, and **in that** N is 432, $b$ is zero and $a$ is 103.

4. Method according to claim 3 **characterized in that** the choice of numbers $a$ and $b$ allows for at least one of the parameters from the group comprising:

- the structure of said frames;
- the structure of said packets.

5. Method according to claim 4 of the type employed in a frequency hopping transmission system using at least two transmission frequencies **characterized in that** said group of parameters also comprises:

- the frequency in use at a given time;
- the frequency hopping times.

6. Method according to any of claims 1 to 5 **characterized in that** it is applied to interleaving digital signals organised into blocks of data elements each comprising N data elements.

7. Method according to any of claims 1 to 6 **characterized in that** said data elements are bits.

8. Method according to any of claims 1 to 7 **characterized in that** it is used in a digital mobile radio system.

9. Method according to any of claims 1 to 8, wherein N is 432, $b$ is 0 and $a$ is 103.

10. Device for determining the parameters of a method of interleaving a source sequence comprising N data elements delivering an interleaved sequence corresponding to said source sequence, said method of interleaving comprising at least one interleaving stage associating the data element of index $j$ of said interleaved sequence to the data element of index $i$ of said source sequence, the value $j$ being determined from the value $i$ as follows:

$$j = (a.i + b) \text{ [modulo N] } + 1$$

where:
$1 \leq i \leq N$ and $1 \leq j$ N;
$a$ is a predetermined integer relatively prime with N and such that:
$2 \leq a \leq N-1$; and
$b$ is a predetermined integer such that:
$0 \leq b \leq N-1$,
**characterized in that** said device includes:

- means for determining a function $f_{N,a,b}$ parametered by the triplet (N, a, b) and such that $q = f_{N,a,b}(p)$, where:

  * $p$ is the number of successive data elements of said source sequence in which there is to be no accumulation of errors so that an error correcting code can correct erroneous data elements;
  * $q$ is the maximum number of successive erroneous data elements of said interleaved sequence corresponding to a fade that a transmission medium on which said interleaved sequence is transmitted can cause without affecting reception at a receiver at the output end of said transmission medium;

- means for calculating, for each separate value of said triplet (N, a, b), a value $p_{min}$ of the number $p$ such that $p_{min}$ is the maximum value of $p$ for which $f_{N,a,b}(p)$ becomes less than or equal to $p$;
- means for choosing numbers $a$ and $b$ corresponding to the maximum value $p_{min}$.

11. Device according to claim 10, wherein N is 432, $b$ is 0 and $a$ is 103.

12. Device (6) for interleaving a source sequence comprising N data elements delivering an interleaved sequence corresponding to said source sequence, said device for interleaving comprising means for carrying out at least one interleaving stage associating the data element of index $j$ of said interleaved sequence to the data element of index $i$ of said source sequence, the value $j$ being determined from the value $i$ as follows:

$$j = (a.i + b) [modulo N] + 1$$

where:

$1 \leq i \leq N$ and $1 \leq j \leq N$;

$a$ is a predetermined integer relatively prime with N and such that:

$2 \leq a \leq N-1$; and

$b$ is a predetermined integer such that:

$0 \leq b \leq N-1$,

**characterized in that**, said device being employed in a system for transmitting data elements in frames (FRAME X, FRAME (X + 1)), each of said frames comprising at least one packet (PACKET 1 to PACKET 4), each of said packets comprising at least two wanted data element areas (31, 32) separated by at least one structure data element area (33 to 35), said device includes means for carrying out said interleaving stage only to said wanted data elements, and **in that** N is 432, $b$ is 0 and $a$ is 103.

**13.** Use of the method according to claim 1 in a system for transmitting data elements in frames (FRAME X, FRAME (X + 1)), each of said frames comprising at least one packet (PACKET 1 to PACKET 4), each of said packets comprising at least two wanted data element areas (31, 32) separated by at least one structure data element area (33 to 35), said interleaving stage is applied only to said wanted data elements [sic].

## Fig. 1

| Indice i des éléments de la séquence SOURCE | Indice j des éléments de la séquence ENTRELACÉE |
|---|---|
| 1 | 5 |
| 2 | 9 |
| 3 | 13 |
| 4 | 17 |
| 5 | 4 |
| 6 | 8 |
| 7 | 12 |
| 8 | 16 |
| 9 | 3 |
| 10 | 7 |
| 11 | 11 |
| 12 | 15 |
| 13 | 2 |
| 14 | 6 |
| 15 | 10 |
| 16 | 14 |
| 17 | 1 |

Exemple : $\begin{cases} N = 17 \\ a = 4 \\ b = 0 \end{cases}$

## Fig. 2

| Paquet 2 | Paquet 3 | Paquet 4 | Paquet 1 | Paquet 2 | Paquet 3 |

TRAME X   TRAME X+1

| Préambule | Données utiles | Midambule | Données utiles | Postambule |

33   31   34   32   35

Fig. 3

Fig. 4